# EUROPEAN PATENT APPLICATION

(11) **EP 4 310 884 A1**
(43) Date of publication of application: **24.01.2024**
(21) Application number: 22186172.7
(22) Date of filing: 21.07.2022
(51) Int. Cl.: H01J 37/244

(54) **CHARGED PARTICLE DETECTOR FOR MICROSCOPY**

(71) Applicant: ASML Netherlands B.V., 5500 AH Veldhoven (NL)
(72) Inventor: BEUKMAN, Arjan, Johannes, Anton, 5500 AH Veldhoven (NL); VAN WEPEREN, Ilse, 5500 AH Veldhoven (NL)
(74) Representative: ASML Netherlands B.V.

(57) **Abstract**

A charged particle detector comprising:
an array of sensing elements configured to generate an electrical signal in response to charged particles and arranged in rows;
an array of optical modulators each connected to a respective one of the sensing elements and configured to modulate a sensing light beam in response to the electrical signal;
a plurality of waveguides configured to direct each of a plurality of sensing light beams through a row of the optical modulators;
a beam combiner configured to combine the plurality of sensing light beams having passed through respective rows of the optical modulator into a combined beam; and
a read out unit configured to measure the modulation of the combined beam to detect charged particles incident on the sensing elements.

## Description

### FIELD

The description herein relates to charged particle detection, and more particularly, to systems and methods that may be applicable to charged particle beam detection.

### BACKGROUND

Detectors may be used for sensing physically observable phenomena. For example, charged particle beam tools, such as electron microscopes, may comprise detectors that receive charged particles projected from a sample and that output a detection signal. Detection signals can be used to reconstruct images of sample structures under inspection and may be used, for example, to reveal defects in the sample. Detection of defects in a sample is increasingly important in the manufacturing of semiconductor devices, which may include large numbers of densely packed, miniaturized integrated circuit (IC) components. Dedicated inspection tools may be provided for this purpose.

In some applications in the field of inspection, for example microscopy using a scanning electron microscope (SEM), an electron beam may be scanned across a sample to derive information from backscattered or secondary electrons generated from the sample. In a related art, electron detection systems in SEM tools may include a detector configured to detect electrons coming from the sample. Existing detectors in SEM tools may detect only the intensity of the beam. Sensitivity in conventional detection systems may be limited by poor signal-to-noise ratio (SNR), particularly when beam current reduces to, for example, pico-ampere ranges. In some detection methods, a large area semiconductor detector or a group of small area semiconductor detectors having an area equal to, smaller, or larger than the area of the beam spot may be used. Current induced by the incoming electron beam may be generated within the detector and then amplified by an amplifier following the detector.

With continuing miniaturization of semiconductor devices, inspection systems may use lower and lower electron beam currents. As beam current decreases, maintaining SNR becomes even more difficult. For example, when probe current decreases to 200 pA or below, SNR may drop off dramatically. Poor SNR may require taking measures such as image averaging or extending the integration time of signal corresponding to each pixel in the image of the sample, which may increase the electron dose on the sample surface, resulting in surface charging artifacts or other detrimental effects. Such measures may also lower the overall throughput of the inspection system.

In a related art, particle counting may be useful in low-current applications. Particle counting may be employed in detectors such as an Everhart-Thornley detector (ETD), which may use a scintillator and a photomultiplier tube (PMT). An ETD may exhibit good SNR in probe current ranges of some applications, such as 8 pA to 100 pA. However, the scintillator's light yield may degrade with accumulated electron dose, and thus has a limited lifetime. Aging of the scintillator may also cause performance drift at the system level and may contribute to generating non-uniform images. Therefore, an ETD may not be appropriate for use in an inspection tool, especially when used in semiconductor manufacturing facilities where it may be required to run 24 hours per day, 7 days per week.

A charged particle detector is needed that can achieve high SNR and that may be used with low probe currents, such as those below 200 pA. Meanwhile, a detector should secure stable quantum efficiency and long lifetime with low performance drift, for example even when used with probe currents of 1 nA or more in continuous operation.

Detection systems employing related art methods may face limitations in detection sensitivity and SNR, particularly at low electron dosages. To improve SNR, related art has proposed a so-called pixelated electron-counting detector in which a detector is sub-divided into a large number of sensing elements whose outputs are combined to generate a detection signal. However, the process of combining the outputs of the individual sensing elements may be slow and/or require complex electronic circuitry. Improvements in detection systems and methods are thus desired.

### SUMMARY

Embodiments of the present disclosure provide a radiation detector comprising:
a set of sensing elements configured to generate an electrical signal in response to radiation;
a set of optical modulators connected to respective ones of the sensing elements and configured to modulate a sensing light beam in response to the electrical signal; and
a sensing optical system configured to direct the sensing light beam through each of the optical modulators.

Embodiments of the present disclosure provide a charged particle detection system comprising:
a set of sensing elements configured to generate an electrical signal in response to radiation;
a set of optical modulators connected to respective ones of the sensing elements and configured to modulate a sensing light beam in response to the electrical signal; and
a sensing optical system configured to direct the sensing light beam through each of the optical modulators.

Embodiments of the present disclosure provide a method of detecting radiation comprising: directing radiation to a plurality of sensing elements that are configured to generate electrical signals in response to the radiation;
modulating a sensing light beam in response to the electrical signals; and measuring the modulation of the sensing light beam to detect the radiation.

Embodiments of the present disclosure provide a charged particle detector comprising:
an array of sensing elements configured to generate an electrical signal in response to charged particles and arranged in rows;
an array of optical modulators each connected to a respective one of the sensing elements and configured to modulate a sensing light beam in response to the electrical signal;
a plurality of waveguides configured to direct each of a plurality of sensing light beams through a row of the optical modulators;
a beam combiner configured to combine the plurality of sensing light beams having passed through respective rows of the optical modulator into a combined beam; and
a read out unit configured to measure the modulation of the combined beam to detect charged particles incident on the sensing elements.

Embodiments of the present disclosure provide a non-transitory computer readable medium including a set of instructions that is executable by one or more processors of a controller to cause the controller to perform a method for controlling deflectors of a charged-particle inspection system, the method comprising:
causing radiation to be directed to a plurality of sensing elements that generate electrical signals in response to the radiation and that are part of a detection component that is configured to modulate a sensing light beam in response to the electrical signals and to measure the modulation of the sensing light beam to detect the radiation; and
causing the detection component to output a signal indicative of the measured modulation.

It is to be understood that both the foregoing general description and the following detailed description are exemplary and explanatory only and are not restrictive of the disclosed embodiments, as may be claimed.

### BRIEF DESCRIPTION OF THE DRAWINGS

The above and other aspects of the present disclosure will become more apparent from the description of exemplary embodiments, taken in conjunction with the accompanying drawings in which:
FIG. 1 is a schematic diagram illustrating an exemplary electron beam inspection (EBI) system, consistent with embodiments of the present disclosure.
FIG. 2A, FIG. 2B, and FIG. 2C are schematic diagrams illustrating exemplary electron beam tools, consistent with embodiments of the present disclosure that may be a part of the exemplary electron beam inspection system of FIG. 1.
FIG. 3 is a schematic diagram of a radiation detector of an embodiment.
FIG. 4 is a schematic cross-section of the radiation detector of FIG. 3.
FIG. 5 is a timing diagram of the radiation detector of FIG. 3.
FIG. 6 is a schematic diagram of a radiation detector of another embodiment.

### DETAILED DESCRIPTION

Reference will now be made in detail to exemplary embodiments, examples of which are illustrated in the drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses, systems, and methods consistent with aspects related to subject matter that may be recited in the appended claims.

Aspects of the present application relate to systems and methods for charged particle beam detection. Systems and methods may employ counting of charged particles, such as electrons, and may be useful in an inspection tool, such as a scanning electron microscope (SEM). Inspection tools may be used in the manufacturing process of integrated circuit (IC) components. To realize the enhanced computing power of modern day electronic devices, the physical size of the devices may shrink while the packing density of circuit components, such as, transistors, capacitors, diodes, etc., is significantly increased on an IC chip. For example, in a smartphone, an IC chip (which may be the size of a thumbnail) may include over 2 billion transistors, the size of each transistor being less than 1/1,000th of a human hair. Not surprisingly, semiconductor IC manufacturing is a complex process, with hundreds of individual steps. Errors in even one step have the potential to dramatically affect the functioning of the final product. The goal of the manufacturing process is to improve the overall yield of the process. For example, for a 50-step process to get 75% yield, each individual step must have a yield greater than 99.4%, and if the individual step yield is 95%, the overall process yield drops to 7%.

It is increasingly important to ensure the ability to detect defects with high accuracy and high resolution while maintaining high throughput (defined as the number of wafer processed per hour, for example). High process yields and high wafer throughput may be impacted by the presence of defects, especially when operator intervention is involved. Thus, detection and identification of micro and nanosized defects by inspection tools (such as a SEM) is important for maintaining high yields and low cost.

In some inspection tools, a sample may be inspected by scanning a beam of high energy electrons over the sample surface. Due to interactions at the sample surface, secondary or backscattered electrons may be generated from the sample that may then be detected by a detector.

Related art detectors may have limitations, for example low read out rates or a requirement for complex electronic circuitry. Aspects of the present disclosure may address some such limitations by providing a radiation detector (for example a charged-particle detector or more specifically an electron detector) having a set of sensing elements; a set of optical modulators coupled to the sensing elements and a sensing optical system to direct a light beam through the optical modulators to enable read out of the detection of radiation by the sensing elements. This optical readout may enable faster readout and/or simpler and smaller components to be packaged on a chip relative to, for example, electronic read out circuitry. The optical readout may have lower power consumption than electronic read out circuitry leading to lower heat dissipation in the vacuum chamber and a reduced requirement for cooling. While the present disclosure discusses some exemplary embodiments in the context of electrons, it will be understood that the present disclosure may be applicable to other types of charged particles, such as ions.

In some embodiments of the present disclosure, a sensing element of an array may be sized such that no more than a certain number of charged particles is received in the area of the individual sensing element per sampling period. The certain number may be one. The size of the sensing element may be smaller than a geometric spread of charged particles incident on the detector. Thus, an individual sensing element may be configured to receive fewer charged particles than the total number of charged particles incident on the detector. According to various criteria, aspects of the detector may be set so as to enable charged particle counting, such as a size of sensing elements, sampling rate, and other characteristics.

Without limiting the scope of the present disclosure, some embodiments may be described in the context of providing detectors and detection methods in systems utilizing electron beams. However, the disclosure is not so limited. Other types of charged particle beams may be similarly applied. Furthermore, systems and methods for detection may be used in other imaging systems, such as optical imaging, photon detection, x-ray detection, ion detection, etc.

As used herein, unless specifically stated otherwise, the term "or" encompasses all possible combinations, except where infeasible. For example, if it is stated that a component includes A or B, then, unless specifically stated otherwise or infeasible, the component may include A, or B, or A and B. As a second example, if it is stated that a component includes A, B, or C, then, unless specifically stated otherwise or infeasible, the component may include A, or B, or C, or A and B, or A and C, or B and C, or A and B and C.

Additionally, the term "detector element" may include or cover "sensing element," "sensor element," "detection cell," or "detector segment," etc.. A sensing element may be a diode configured to have a depletion region, and in some embodiments discussed herein, the term "sensing element" may exclude an avalanche diode operating in Geiger mode. A detector element may include a diode, an interconnect, and a circuit, which may include front-end electronics, for example. Furthermore, the term "frame" may include or cover "sampling period," "SEM image pixel period," or "pixel period," etc. A SEM image frame may refer to a frame of pixels that may be refreshed on a frame-by-frame basis, while a data frame may refer to a group of data acquired by a detection system within a specified period of time.

Embodiments of the present disclosure may provide a detection method. The detection method may comprise charged particle counting. For example, in some embodiments, a charged particle detection method may be provided for electron microscopy. The method may be applied to a SEM detection system. The charged particle detection method may be based on electron counting. By counting the number of electrons received during a pre-defined period, the intensity of an incoming electron beam may be determined. The term "incoming electron" may include or cover an incident electron, such as an electron that impacts the surface of a detector. According to some embodiments, noise from the charged particle detection process may be reduced. However, solely improving SNR may not fulfill the ever increasing needs of various SEM applications.

Electron counting may involve determining individual electron arrival events occurring at a detector. For example, electrons may be detected one-by-one as they reach the detector. In some embodiments, electrons incident on a detector may generate an electrical signal that is routed to an electro-optic modulator that selectively modulates a light beam, by changing a parameter thereof such as phase, amplitude or polarization. Signal processing circuitries detect the modulation of the light beam and then read-out to an interface, such as a digital controller. A detector may be configured to resolve signals generated by incident electrons and distinguish individual electrons with a discrete count.

In some embodiments, electron counting may be applied to situations in which beam current is very small. For example, an electron beam may be set to irradiate a sample with a low dose. Low current may be used to prevent oversaturation of an electron counting detector by large current. For example, large current may have the effect of introducing nonlinearity in detection results. Meanwhile, for a detector that may be used in an industrial setting, the detector should also be able to handle situations of large beam current.

Some embodiments may address the above issues. For example, some embodiments may provide a plurality of relatively small sensing elements that may be used to detect an electron beam. Isolation may be provided between adjacent sensing elements so that the probability of one incoming electron going from one sensing element to its adjacent sensing elements may be reduced. In this way, crosstalk between adjacent sensing elements may be reduced.

In some embodiments, a detector may be constructed using digital circuitry and optoelectronic elements rather than implementations requiring a large amount of analog or digital electronic circuits. Accordingly, various aspects of implementation of a detector, such as operating speed, may be improved.

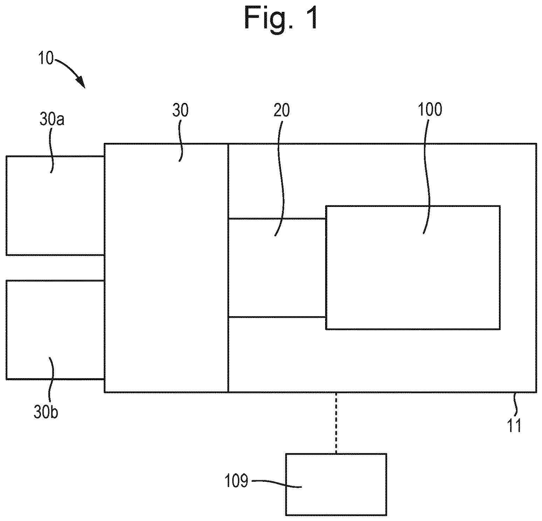

Reference is now made to FIG. 1, which illustrates an exemplary electron beam inspection (EBI) system 10 that may include a detector, consistent with embodiments of the present disclosure. EBI system 10 may be used for imaging. As shown in FIG. 1, EBI system 10 includes a main chamber 11 a load/lock chamber 20, an electron beam tool 100, and an equipment front end module (EFEM) 30. Electron beam tool 100 is located within main chamber 11. EFEM 30 includes a first loading port 30a and a second loading port 30b. EFEM 30 may include additional loading port(s). First loading port 30a and second loading port 30b receive wafer front opening unified pods (FOUPs) that contain wafers (e.g., semiconductor wafers or wafers made of other material(s)) or samples to be inspected (wafers and samples may be collectively referred to as "wafers" herein).

One or more robotic arms (not shown) in EFEM 30 may transport the wafers to load/lock chamber 20. Load/lock chamber 20 is connected to a load/lock vacuum pump system (not shown) which removes gas molecules in load/lock chamber 20 to reach a first pressure below the atmospheric pressure. After reaching the first pressure, one or more robotic arms (not shown) may transport the wafer from load/lock chamber 20 to main chamber 11. Main chamber 11 is connected to a main chamber vacuum pump system (not shown) which removes gas molecules in main chamber 11 to reach a second pressure below the first pressure. After reaching the second pressure, the wafer is subject to inspection by electron beam tool 100. Electron beam tool 100 may be a single-beam system or a multi-beam system. A controller 109 is electronically connected to electron beam tool 100, and may be electronically connected to other components as well. Controller 109 may be a computer configured to execute various controls of EBI system 10. While controller 109 is shown in FIG. 1 as being outside of the structure that includes main chamber 11, load/lock chamber 20, and EFEM 30, it is appreciated that controller 109 can be part of the structure.

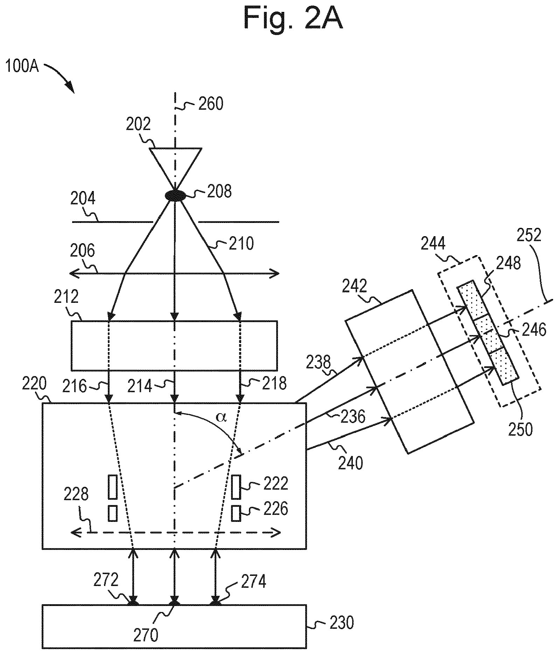

FIG. 2A illustrates a charged particle beam apparatus in which an inspection system may comprise a multi-beam inspection tool that uses multiple primary electron beamlets to simultaneously scan multiple locations on a sample.

As shown in FIG. 2A, an electron beam tool 100A (also referred to herein as apparatus 100A) may comprise an electron source 202, a gun aperture 204, a condenser lens 206, a primary electron beam 210 emitted from electron source 202, a source conversion unit 212, a plurality of beamlets 214, 216, and 218 of primary electron beam 210, a primary projection optical system 220, a wafer stage (not shown in FIG. 2A), multiple secondary electron beams 236, 238, and 240, a secondary optical system 242, and an electron detection device 244. Electron source 202 may generate primary particles, such as electrons of primary electron beam 210. A controller, image processing system, and the like may be coupled to electron detection device 244. Primary projection optical system 220 may comprise a beam separator 222, deflection scanning unit 226, and objective lens 228. Electron detection device 244 may comprise detection sub-regions 246, 248, and 250.

Electron source 202, gun aperture 204, condenser lens 206, source conversion unit 212, beam separator 222, deflection scanning unit 226, and objective lens 228 may be aligned with a primary optical axis 260 of apparatus 100A. Secondary optical system 242 and electron detection device 244 may be aligned with a secondary optical axis 252 of apparatus 100A.

Electron source 202 may comprise a cathode, an extractor or an anode, wherein primary electrons can be emitted from the cathode and extracted or accelerated to form a primary electron beam 210 with a crossover (virtual or real) 208. Primary electron beam 210 can be visualized as being emitted from crossover 208. Gun aperture 204 may block off peripheral electrons of primary electron beam 210 to reduce size of probe spots 270, 272, and 274.

Source conversion unit 212 may comprise an array of image-forming elements (not shown in FIG. 2A) and an array of beam-limit apertures (not shown in FIG. 2A). An example of source conversion unit 212 may be found in U.S. Pat. No. 9,691,586; U.S. Publication No. 2017/0025243; and International Application No. PCT/EP2017/084429, all of which are incorporated by reference in their entireties. The array of image-forming elements may comprise an array of micro-deflectors or microlenses. The array of image-forming elements may form a plurality of parallel images (virtual or real) of crossover 208 with a plurality of beamlets 214, 216, and 218 of primary electron beam 210. The array of beam-limit apertures may limit the plurality of beamlets 214, 216, and 218.

Condenser lens 206 may focus primary electron beam 210. The electric currents of beamlets 214, 216, and 218 downstream of source conversion unit 212 may be varied by adjusting the focusing power of condenser lens 206 or by changing the radial sizes of the corresponding beam-limit apertures within the array of beam-limit apertures. Condenser lens 206 may be a moveable condenser lens that may be configured so that the position of its first principle plane is movable. The movable condenser lens may be configured to be magnetic, which may result in off-axis beamlets 216 and 218 landing on the beamlet-limit apertures with rotation angles. The rotation angles change with the focusing power and the position of the first principal plane of the movable condenser lens. In some embodiments, the moveable condenser lens may be a moveable anti-rotation condenser lens, which involves an anti-rotation lens with a movable first principal plane. A moveable condenser lens is further described in U.S. Publication No. 2017/0025241, which is incorporated by reference in its entirety.

Objective lens 228 may focus beamlets 214, 216, and 218 onto a wafer 230 for inspection and may form a plurality of probe spots 270, 272, and 274 on the surface of wafer 230.

Beam separator 222 may be a beam separator of Wien filter type generating an electrostatic dipole field and a magnetic dipole field. In some embodiments, if they are applied, the force exerted by electrostatic dipole field on an electron of beamlets 214, 216, and 218 may be equal in magnitude and opposite in direction to the force exerted on the electron by magnetic dipole field. Beamlets 214, 216, and 218 can therefore pass straight through beam separator 222 with zero deflection angle. However, the total dispersion of beamlets 214, 216, and 218 generated by beam separator 222 may also be non-zero. Beam separator 222 may separate secondary electron beams 236, 238, and 240 from beamlets 214, 216, and 218 and direct secondary electron beams 236, 238, and 240 towards secondary optical system 242.

Deflection scanning unit 226 may deflect beamlets 214, 216, and 218 to scan probe spots 270, 272, and 274 over a surface area of wafer 230. In response to incidence of beamlets 214, 216, and 218 at probe spots 270, 272, and 274, secondary electron beams 236, 238, and 240 may be emitted from wafer 230. Secondary electron beams 236, 238, and 240 may comprise electrons with a distribution of energies including secondary electrons and backscattered electrons. Secondary optical system 242 may focus secondary electron beams 236, 238, and 240 onto detection sub-regions 246, 248, and 250 of electron detection device 244. Detection sub-regions 246, 248, and 250 may be configured to detect corresponding secondary electron beams 236, 238, and 240 and generate corresponding signals used to reconstruct an image of surface area of wafer 230.

Although FIG. 2A shows an example of electron beam tool 100 as a multi-beam tool that uses a plurality of beamlets, embodiments of the present disclosure are not so limited. For example, electron beam tool 100 may also be a single-beam tool that uses only one primary electron beam to scan one location on a wafer at a time.

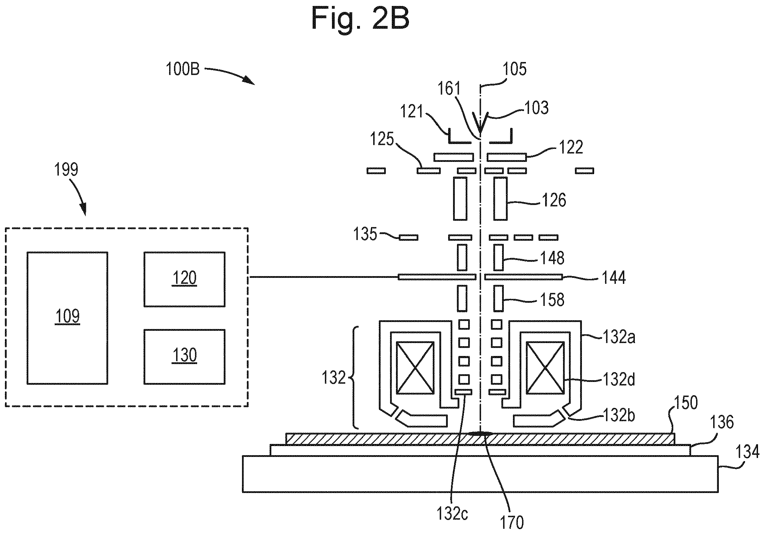

As shown in FIG. 2B, an electron beam tool 100B (also referred to herein as apparatus 100B) may be a single-beam inspection tool that is used in EBI system 10. Apparatus 100B includes a wafer holder 136 supported by motorized stage 134 to hold a wafer 150 to be inspected. Electron beam tool 100B includes an electron emitter, which may comprise a cathode 103, an anode 121, and a gun aperture 122. Electron beam tool 100B further includes a beam limit aperture 125, a condenser lens 126, a column aperture 135, an objective lens assembly 132, and a detector 144. Objective lens assembly 132, in some embodiments, may be a modified SORIL lens, which includes a pole piece 132a, a control electrode 132b, a deflector 132c, and an exciting coil 132d. In an imaging process, an electron beam 161 emanating from the tip of cathode 103 may be accelerated by anode 121 voltage, pass through gun aperture 122, beam limit aperture 125, condenser lens 126, and be focused into a probe spot 170 by the modified SORIL lens and impinge onto the surface of wafer 150. Probe spot 170 may be scanned across the surface of wafer 150 by a deflector, such as deflector 132c or other deflectors in the SORIL lens. Secondary or scattered primary particles, such as secondary electrons or scattered primary electrons emanated from the wafer surface may be collected by detector 144 to determine intensity of the beam and so that an image of an area of interest on wafer 150 may be reconstructed.

There may also be provided an image processing system 199 that includes an image acquirer 120, a storage 130, and controller 109. Image acquirer 120 may comprise one or more processors. For example, image acquirer 120 may comprise a computer, server, mainframe host, terminals, personal computer, any kind of mobile computing devices, and the like, or a combination thereof. Image acquirer 120 may connect with detector 144 of electron beam tool 100B through a medium such as an electrical conductor, optical fiber cable, portable storage media, IR, Bluetooth, Internet, wireless network, wireless radio, or a combination thereof. Image acquirer 120 may receive a signal from detector 144 and may construct an image. Image acquirer 120 may thus acquire images of wafer 150. Image acquirer 120 may also perform various post-processing functions, such as generating contours, superimposing indicators on an acquired image, and the like. Image acquirer 120 may be configured to perform adjustments of brightness and contrast, etc. of acquired images. Storage 130 may be a storage medium such as a hard disk, random access memory (RAM), cloud storage, other types of computer readable memory, and the like. Storage 130 may be coupled with image acquirer 120 and may be used for saving scanned raw image data as original images, and post-processed images. Image acquirer 120 and storage 130 may be connected to controller 109. In some embodiments, image acquirer 120, storage 130, and controller 109 may be integrated together as one electronic control unit.

In some embodiments, image acquirer 120 may acquire one or more images of a sample based on an imaging signal received from detector 144. An imaging signal may correspond to a scanning operation for conducting charged particle imaging. An acquired image may be a single image comprising a plurality of imaging areas that may contain various features of wafer 150. The single image may be stored in storage 130. Imaging may be performed on the basis of imaging frames.

The condenser and illumination optics of the electron beam tool may comprise or be supplemented by electromagnetic quadrupole electron lenses. For example, as shown in FIG. 2B, electron beam tool 100B may comprise a first quadrupole lens 148 and a second quadrupole lens 158. In some embodiments, the quadrupole lenses are used for controlling the electron beam. For example, first quadrupole lens 148 can be controlled to adjust the beam current and second quadrupole lens 158 can be controlled to adjust the beam spot size and beam shape.

FIG. 2B illustrates a charged particle beam apparatus in which an inspection system may use a single primary beam that may be configured to generate secondary electrons by interacting with wafer 150. Detector 144 may be placed along optical axis 105, as in the embodiment shown in FIG. 2B. The primary electron beam may be configured to travel along optical axis 105. Accordingly, detector 144 may include a hole at its center so that the primary electron beam may pass through to reach wafer 150. 224However, some embodiments may use a detector placed off-axis relative to the optical axis along which the primary electron beam travels. For example, as in the embodiment shown in FIG. 2A, beam separator 222 may be provided to direct secondary electron beams toward a detector placed off-axis. Beam separator 222 may be configured to divert secondary electron beams by an angle α.

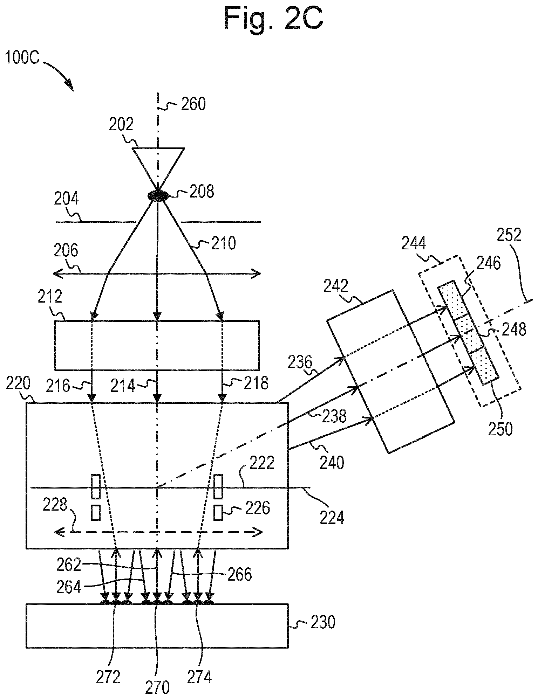

Another example of a charged particle beam apparatus will now be discussed with reference to FIG. 2C. Electron beam tool 100C (also referred to herein as apparatus 100C) may be an example of electron beam tool 100 and may be similar to electron beam tool 100A shown in FIG. 2A.

As shown in FIG. 2C, beam separator 222 may be a beam separator of Wien filter type generating an electrostatic dipole field and a magnetic dipole field. In some embodiments, if they are applied, the force exerted by electrostatic dipole field on an electron of beamlets 214, 216, and 218 may be equal in magnitude and opposite in direction to the force exerted on the electron by magnetic dipole field. Beamlets 214, 216, and 218 can therefore pass straight through beam separator 222 with zero deflection angle. However, the total dispersion of beamlets 214, 216, and 218 generated by beam separator 222 may also be non-zero. For a dispersion plane 224 of beam separator 222, FIG. 2C shows dispersion of beamlet 214 with nominal energy V0 and an energy spread ΔV into beamlet portions 262 corresponding to energy V0, beamlet portion 264 corresponding to energy V0+ΔV/2, and beamlet portion 266 corresponding to energy V0-ΔV/2. The total force exerted by beam separator 222 on an electron of secondary electron beams 236, 238, and 240 can be non-zero. Beam separator 222 may separate secondary electron beams 236, 238, and 240 from beamlets 214, 216, and 218 and direct secondary electron beams 236, 238, and 240 towards secondary optical system 242.

A semiconductor electron detector (sometimes called a "PIN detector") may be used in apparatus 100 in EBI system 10. EBI system 10 may be a high-speed wafer imaging SEM including an image processor. An electron beam generated by EBI system 10 may irradiate the surface of a sample or may penetrate the sample. EBI system 10 may be used to image a sample surface or structures under the surface, such as for analyzing layer alignment. In some embodiments, EBI system 10 may detect and report process defects relating to manufacturing semiconductor wafers by, for example, comparing SEM images against device layout patterns, or SEM images of identical patterns at other locations on the wafer under inspection. A PIN detector may include a silicon PIN diode that may operate with negative bias. A PIN detector may be configured so that incoming electrons generate a relatively large and distinct detection signal. In some embodiments, a PIN detector may be configured so that an incoming electron may generate a number of electron-hole pairs while a photon may generate just one electron-hole pair. A PIN detector used for electron counting may have numerous differences as compared to a photodiode used for photon detection, as shall be discussed as follows.

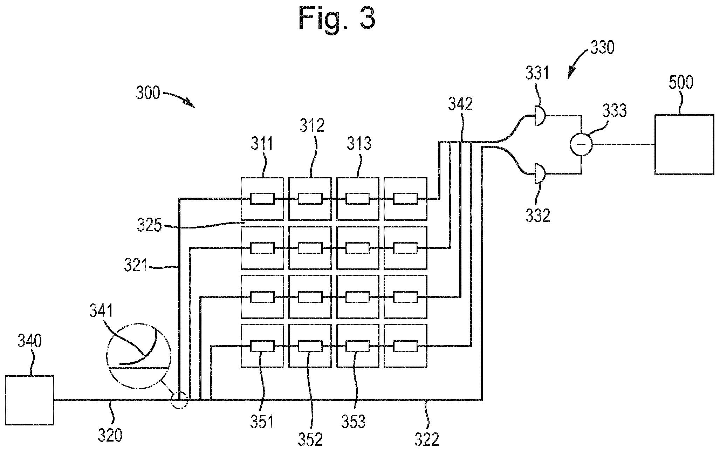

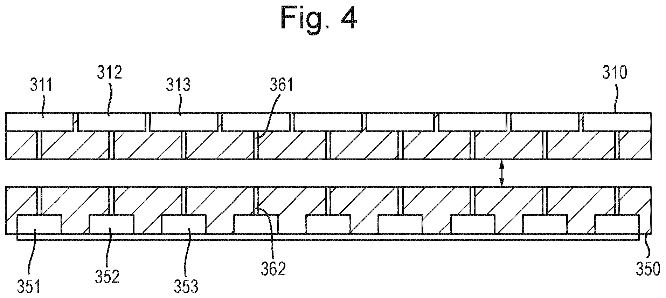

Reference is now made to FIGs. 3 and 4, which illustrate a schematic representation of an exemplary structure of a detector 300. Detector 300 may be provided as detector 144 or electron detection device 244 with reference to FIG. 2A, FIG. 2B, and FIG. 2C.

Briefly, detector 300 comprises: sensing elements 311, 312, 313 for generating electrical signals in response to radiation; optical modulators 351, 352, 353 for modulating light beams in response to the electrical signals; optical system 320, 321, 322 for guiding light beams to the optical modulators; light source 340 for generating a light beam; and read out circuit 330 for providing an electron count output signal to data processor 500. There may be a large number of sensing elements, e.g. 1,000 or more, desirably 5,000 or more, more desirably 10,000 or more. These components are described in more detail below.

Detector 300 may comprise an array of sensing elements, including sensing elements 311, 312, and 313. The sensing elements may be arranged in a planar, two-dimensional array, the plane of the array being substantially perpendicular to an incidence direction of incoming charged particles. In some embodiments, detector 300 may be arranged so as to be inclined relative to the incidence direction. The array may comprise 10 or more rows, desirably 50 or more rows, more desirably 100 or more rows, with each row comprising 10 or more sensing elements, desirably 50 or more sensing elements, more desirably 100 or more sending elements. While one array is shown in FIG. 3, it is appreciated that detector 300 may include multiple arrays, such as one array for each secondary electron beam.

Detector 300 may comprise a substrate 310. Substrate 310 may be a semiconductor substrate that may include the sensing elements. A sensing element may be a diode. A sensing element may also be an element similar to a diode that can convert incident energy into a measurable signal. The sensing elements may comprise, for example, a PIN diode, an avalanche diode, an electron multiplier tube (EMT), etc., or combinations thereof. An area 325 may be provided between adjacent sensing elements. Area 325 may be an isolation area to isolate the sides or corners of neighboring sensing elements from one another. Area 325 may comprise an insulating material that is a material different from that of other areas of the detection surface of detector 300. Area 325 may be provided as a cross-shaped area as seen in the plane view of FIG. 3. Area 325 may be provided as a square. In some embodiments, area 325 may not be provided between adjacent sides of sensing elements. For example, in some embodiments, there may be no isolation area provided on a detection surface of a detector.

Sensing elements may generate an electric signal commensurate with charged particles received in the active area of a sensing element. For example, a sensing element may generate an electric current signal commensurate with the energy of a received electron. A pre-processing circuit may convert the generated current signal into a voltage that may represent the intensity of an electron beam spot or a part thereof. The pre-processing circuitry may comprise, for example, pre-amp circuitries. Pre-amp circuitries may include, for example, a charge transfer amplifier (CTA), a transimpedance amplifier (TIA), an impedance conversion circuit coupled with a CTA or a TIA or a three-transistor amplifier. In some embodiments, signal processing circuitry may be provided that provides an output signal in arbitrary units on a timewise basis. There may be provided one or a plurality of substrates, such as dies, that may form circuit layers for processing the output of sensing elements. The dies may be stacked together in a thickness direction of the detector. Other circuitries may also be provided for other functions. For example, switch actuating circuitries may be provided that may control switching elements for connecting sensing elements to one another.

Although the figures may show sensing elements 311, 312, and 313 as discrete units, such divisions may not actually be present. For example, the sensing elements of a detector may be formed by a semiconductor device constituting a PIN diode device. The PIN diode device may be manufactured as a substrate with a plurality of layers including a p-type region, an intrinsic region, and an n-type region. One or more of such layers may be contiguous in cross-sectional view. In some embodiments, however, sensing elements may be provided with physical separation between them. Further layers may also be provided in addition to the sensor layer, such as a circuit layer, and a read-out layer, for example.

As one example of a further layer, detector 300 may be provided with one or more circuit layers adjacent to the sensor layer. The one or more circuit layers may comprise line wires, interconnects, and various electronic circuit components. The one or more circuit layers may comprise a processing system. The one or more circuit layers may comprise signal processing circuitries. The one or more circuit layers may be configured to receive the output current detected from sensing elements in the sensor layer. The one or more circuit layers and the sensor layer may be provided in the same or separate dies, for example.

Further details of the operation of a detection element, such as a diode, for detection of electrons can be found in US2019/0378682A1, which document is hereby incorporate by reference in its entirety. As an alternative to PIN diodes, embodiments may employ Low Gain Avalanche diodes (LGAD).

Each of the sensing elements 311, 312, 313 outputs an electrical signal, which may be referred to as a detection signal, in response to an incident charged particle, specifically an electron. The detection signal may be, for example, a signal in amperes, volts, or arbitrary units commensurate with energy of electrons received at the respective sensing element. In some embodiments, the detection signal may represent the number of charged particles incident on sensing elements of the detector within a time period, e.g. a frame. The detection signal may indicate that a discrete number of charged particles has arrived at a sensing element. The number of charged particles may be discerned as a whole number.

The radiation receiving part of the sensing element, e.g. the PIN diode, may emit a brief pulse of current when a charged particle is incident. The sensing element may therefore include a persistent element, such as an accumulator or sample and hold circuit, that is set to an "on" state by the pulse of current or accumulates charge in response to the pulse of current until reset by a reset circuit at the end of a sampling period or frame. The sampling period or frame rate may be set in advance or automatically determined on the basis of operating conditions.

As depicted in FIGs. 3 and 4, each sensing element 311, 312, 313 is connected to respective one of optical modulators 351, 352, 353, which may also be referred to as electro-optic devices. It is to be noted that a one-to-one relationship between sensing elements and optical modulators is not required; in embodiments there may be a one-to two relationship, a one-to-many relationship, a two-to-one relationship, a many-to-one relationship, etc.. In response to the output from the respective sensing element(s), each optical modulator applies a modulation to the light beam passing through it. The optical modulation may be a change in a parameter of the beam such as phase, amplitude or polarization, or a combination thereof. The change may be binary (i.e. if the electrical signal output by the sensing element indicates one or more charged particles have been detected then a modulation is applied, otherwise not, or vice versa), multi-valued or analog.

The parameter change is desirably cumulative and linearly additive. For example if the optical modulators selectively apply a phase delay of δ, then a light beam that has passed through *n* active optical modulators will be delayed by an amount equal to *nδ*. The phase delay δ is desirably selected so that the total delay imparted when a maximum expected number of charged particles is detected is less than 2π. However the phase delay δ need not be less than 2π divided by the total number of optical modulators. The phase delay imparted by an optical modulator may be determined by design of the optical path length of the optical modulator and/or the voltage applied to it. Details of suitable optical modulators are given in Abdul Rahim, Artur Hermans, Benjamin Wohlfeil, Despoina Petousi, Bart Kuyken, Dries Van Thourhout, and Roel G. Baets "Taking silicon photonics modulators to a higher performance level: state-of-the-art and a review of new technologies," Advanced Photonics 3(2), 024003 (29 April 2021). https://doi.org/10.1117/1.AP.3.2.024003. Desirably, all of the optical modulators may be constructed using silicon-photonic techniques on a single substrate 350 as a single integrated circuit device. Alternatively separate devices may be used.

In an arrangement where the modulation is linearly additive, the total modulation of the measurement beam represents a sum of the incident radiation on all the sensing elements with which the measurement beam is associated. In some embodiments, a weighted sum can be desirable and is achieved by introducing a weighting factor for each sensing element. The weighting factor may, for example vary between 0 and 1. A weighting factor can be implemented in several different ways. For example, the weighting factor may be applied to the gain of an electronic amplifier associated with each sensing element. The weighting factor can be applied in the modulator, e.g. by varying the voltage of the phase modulator. The per-sensing element weighting factors may be fixed at the time of manufacture or calibration or may be variable during use of the device.

The light beam that is modulated, which may be referred to as the sensing light beam, may be generated by a light source 340 mounted on the same substrate 350 as the optical modulators 351, 352, 353 or remotely with fiber optics used to bring the light to the optical modulators. Mounting the light source on substrate 350 may make the device more compact. Having a remote light source may reduce heat dissipation in the detector. The wavelength of the light output by light source 340 is not particularly limited and is desirably selected for compatibility with the optical modulators to be used. A wavelength in the infrared, visible or ultraviolet ranges is likely to be suitable. Desirably light source 340 outputs substantially monochromatic light, e.g. if phase modulation is to be used. A light source emitting multiple wavelengths may be usable in some embodiments. A broadband source may be suitable if amplitude modulation is used. Light source 340 may be, for example, a laser diode emitting in the infrared range, e.g. at 1550 nm.

Light source 340 is coupled (either directly or via an optical fiber) to input waveguide 320. A beam splitter 341 divides the input light beam to a plurality of sensing waveguides 321 (which are examples of sensing optical systems), thereby forming a plurality of sensing beams. Each of the sensing waveguides 321 guides the respective sensing beam through a set of optical modulators 351, 352, 353. For example, as depicted in FIG. 3, each set of optical modulators forms a row of the array of optical modulators and the sensing light beam follows a straight beam path through the optical modulators, but other arrangements are possible as discussed below.

After the sensing beams have passed through the optical modulators, a beam combiner 342 combines the sensing beams into a measurement beam which passes to a read out unit 330. After combination of the sensing beams, the modulation of the measurement beam may be the average of the modulations of the sensing beams. For example, in an arrangement with 100 rows of 100 sensing elements and optical modulators, if only one optical modulator is active and applies a phase delay of δ, the phase delay of the measurement beam will be δ/100. If 50 optical modulators are active, the phase delay of the measurement beam will be δ/2. A reference waveguide 322 (as an example of a reference optical system) may be provided to pass a reference beam directly to read out unit 330 without passing through any of the optical modulators. The reference waveguide may be configured to have substantially the same optical path length as the sensing waveguides and to impart the same effect, e.g. attenuation, as imparted by the beam path of the sensing light beam(s) when no optical modulators are active. As an alternative to combining all of the beams to be measured by a single read out unit, a plurality of read out units may be provided, each measuring one sensing beams or a combination of a subset of the sensing beams.

The structure of readout unit 330 depends on the parameter to be measured. If the modulated parameter is phase, the read out unit may comprise an interferometer. If the modulated parameter is amplitude, the read out unit may comprise a power sensor. If the modulated parameter is polarization, the read out unit may comprise a polarization analyzer. Read out unit 330 may measure the modulated parameter by comparing the measurement beam, that has been derived from the separate sensing beams that passed through the optical modulators, with a reference beam which is also derived from the source 340 but is guided to the read out unit 330 by reference waveguide 322 without passing through any optical modulator. Where a reference beam is used, the read out unit is desirably configured in a balanced detection set up (having optical detectors 331, 332 for the measurement and reference beams respectively and a comparator 333 as shown in FIG. 3) so that common-mode fluctuations (e.g. laser intensity noise) are suppressed. If amplitude modulation is used, the reference beam may be omitted. Alternatively the reference beam may be used with a static phase delay so that destructive interference with the measurement beam occurs. When a charged particle is detected, the measurement beam is attenuated and the destructive interference is no longer complete, hence light is detected at the read out unit. This may be easier than making an absolute measurement of beam intensity.

Read out unit 330 is configured to measure the modulation of the measurement beam and to output a signal to data processor 500 which is representative of the charged particles incident during a measurement period or frame, desirably the number of charged particles. Read out unit 330 may comprise other signal processing elements, e.g. an analog to digital converter, that process the result of measuring the modulation of the measurement beam to generate the output signal which is representative of the charged particles incident on the sensing elements. Signal processor 500 may also include a digital switch, a digital control unit, or a controller configured to perform image processing, among other things. Further circuitries may be provided in the architecture, such as a signal processing path that is configured to provide gain and offset control, for example.

As depicted in FIG. 4, sensing elements 311, 312, 313 may be formed on a first substrate 310 and optical modulators 351, 352, 353 may be formed on a second substrate 350. The first substrate 310 and second substrate 350 are placed back-to-back and bonded. Connections between the sensing elements 311, 312, 313 and optical modulators 351, 352, 353 can be made by through-silicon vias 361, 362. Mounting the first and second substrates back-to-back in this way minimizes the lengths if signal paths between the sensing elements and corresponding optical modulators and so maximizes the speed of operation of the detector. Such an arrangement is feasible because the optical modulators can be smaller than the sensing elements and still impart a detectable phase shift. The sensing elements 311, 312, 313 and optical modulators 351, 352, 353, together with any other related elements such as amplifiers, may be referred to collectively as a detection component.

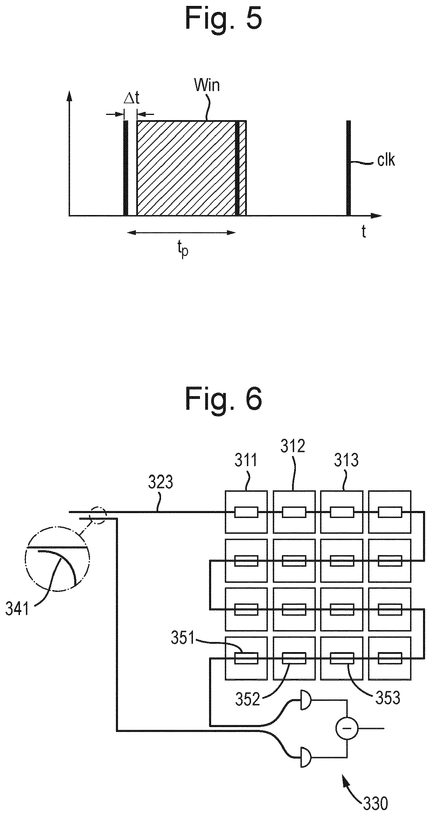

A SEM system may scan a primary electron beam across a sample in a pattern, such as a raster pattern. Pixels to be generated in an image may be associated with locations of the scanned sample surface. The pixels may be correlated with a particular scan time. Data from a detector may be correlated with the scan time. A scaler may be used to correlate data received from a detector to a particular scan time. A scaler may be configured to correlate detector data with a scan time (and thus, a pixel) based on a delay time. For example, a scaler may record a time at which data associated with an electron arrival event is received and apply a correction based on a delay from a trigger. The trigger may correspond to an electron of a primary electron beam impinging on a sample. The delay may take into account travel time of electrons (e.g., secondary electrons) from the sample to the detector, or time for a signal pulse in a sensing element to be generated and output. In addition, the time Δt taken for the light beam(s) to propagate through the sensing waveguides and the optical modulators may in some cases be non-negligible. Therefore, as depicted in FIG. 5, the sampling window Win for the read-out unit 330 is desirably offset from the pixel clock clk, which defines pixel boundaries, by the time Δt for the light beam(s) to propagate through the sensing waveguides and the optical modulators. In general, Δt is much less than the period tₚ for the pixel clock clk.

As previously mentioned, other arrangements for the sensing waveguides are possible. FIG. 6 depicts one such arrangement wherein a single sensing waveguide 323 guides the sensing beam along a meandering path that passes through all the optical modulators 351, 352, 353. It will be appreciated that if the optical path traversed by the sensing beam is longer the time taken is longer and the maximum sampling rate is reduced. Therefore, the selection of the optical path is a trade-off between simplicity of the device (through reduced number of beam splitters and combiners) and desired sampling rate. For example, rather than (as in FIG. 3) each sensing beam passing through one row of optical modulators, each sensing beam could pass through a fraction of a row (to increase the sampling rate) or more than one row (where a lower sampling rate is sufficient). Where there are multiple optical paths for sensing beams that are then combined and interfere with the reference beam, it is desirable that the optical path lengths are equal up to the coherence length of the light source. In some embodiments, it is possible to achieve a high rate of sampling. Therefore, the read out unit may be configured to operate at a rate of no less than 100 MHz, desirably no less than 200 MHz, more desirably no less than 400 MHz.

In some embodiments, a beam spot on a detector surface may be larger than a beam spot on a sample surface. Accordingly, the overall size of a detection surface of a detector may be configured to be large enough to accommodate a broad beam spot. The beam spot on the detector surface may be on the order of a few millimeters in diameter. However, increasing a size of a detector may contribute to noise effects. For example, the capacitance of a detector may be proportional to an area of a detector surface. Some sources of noise, such as that due to components being coupled to a detector (e.g., an amplifier), may be related to capacitance.

In some embodiments, the area of a sensing element may be reduced by configuring the sensing element to be smaller than the geometric spread of secondary electrons incident on a whole detector surface. Signal and capacitance of a detector sensing element may be proportional to the area of the sensing element in a case where the sensing element is fully covered by a beam spot. In some cases, the sensing element may be only partially covered by a beam spot. SNR reduction due to capacitance may be mitigated by decreasing the sensing element area when the sensing element is not fully covered by a beam spot.

In some embodiments, an area ratio, which may be the ratio of area of an individual sensing element to that of the entire surface of a detector, may be varied. The area ratio may have a corresponding relationship to SNR. For example, in some embodiments, decreasing the size of a sensing element to be 1/1,000 of the area of a detector may correspond to a 1,000× increase in SNR.

In some embodiments, a detector may include an array of sensing elements. The array may include a plurality of sensing elements each having dimensions of Dx and Dy, or less, for example. For example, each of the sensing elements may have a radiation receiving area having a size no more than 500 µm by 500 µm, desirably no more than 200 µm by 200 µm, more desirably no more than 150 µm by 150 µm. In some embodiments, the radiation detector may comprise no less than 1,000 sensing elements, desirably no less than 5,000 sensing elements, more desirably no less than 10,000 sensing elements. The sensing elements may be arranged in a planar, two-dimensional array, the plane of the array being substantially perpendicular to an incidence direction of incoming charged particles. In some embodiments, the detector may be arranged so as to be inclined relative to the incidence direction.

In some embodiments, sensing elements may be capable of distinguishing between incident electrons having different energy, e.g. to distinguish between backscattered electrons and secondary electrons. Such a sensor may output a plurality of independent signals, each of the independent signals indicating the number or intensity of received electrons of a particular type or range of energies. In such a case, various different approaches can be used to separately read out the independent signals. For example a plurality of independent modulators may be provided per sensing element, one for each of the independent signals. The plurality of independent modulators may be applied to modulate different parameters of a single beam, to modulate separate beams travelling on separate optical paths, or to modulate beams of different wavelength travelling on the same optical path, or some combination of these approaches.

A variety of results may be acquired according to specific application requirements based on the same set of acquired raw data. Results may be used in post processing rather than in pre-processing. In some embodiments, pre-processing may include sensing element grouping. Data may be further tailored for optimizing specific purposes. For example, a trade-off relationship may exist between optimizing detection parameters such as cross talk and secondary charged particle collection efficiency. However, when post processing is used to adjust data, the trade-off may be adjusted without loss of information. This may provide application layers with more flexibility and may reduce the risk of having to redo specific operations merely to obtain data with different detection parameter settings.

In some embodiments, a detector may communicate with a controller that controls a charged particle beam system. The controller may instruct components of the charged particle beam system to perform various functions, such as controlling a charged particle source to generate a charged particle beam and controlling a deflector to scan the charged particle beam. The controller may also perform various other functions such as adjusting a sampling rate of a detector, resetting sensing element, or performing image processing. The controller may comprise a storage that is a storage medium such as a hard disk, random access memory (RAM), other types of computer readable memory, and the like. The storage may be used for saving scanned raw image data as original images, and post-processed images. A non-transitory computer readable medium may be provided that stores instructions for a processor of controller 109 to carry out charged particle beam detection, sampling period determination, image processing, or other functions and methods consistent with the present disclosure. Common forms of non-transitory media include, for example, a floppy disk, a flexible disk, hard disk, solid state drive, magnetic tape, or any other magnetic data storage medium, a CD-ROM, any other optical data storage medium, any physical medium with patterns of holes, a ROM, a PROM, and EPROM, a FLASH-EPROM or any other flash memory, NVRAM, a cache, a register, any other memory chip or cartridge, and networked versions of the same.

Block diagrams in the figures may illustrate the architecture, functionality, and operation of possible implementations of systems, methods, and computer hardware/software products according to various exemplary embodiments of the present disclosure. In this regard, each block in a schematic diagram may represent certain arithmetical or logical operation processing that may be implemented using hardware such as an electronic circuit. Blocks may also represent a module, segment, or portion of code that comprises one or more executable instructions for implementing the specified logical functions. It should be understood that in some alternative implementations, functions indicated in a block may occur out of the order noted in the figures. For example, two blocks shown in succession may be executed or implemented substantially concurrently, or two blocks may sometimes be executed in reverse order, depending upon the functionality involved. Some blocks may also be omitted. It should also be understood that each block of the block diagrams, and combination of the blocks, may be implemented by special purpose hardware-based systems that perform the specified functions or acts, or by combinations of special purpose hardware and computer instructions.

Exemplary embodiments of the invention are set out in the following numbered clauses:
1. A radiation detector comprising:
   a set of sensing elements configured to generate an electrical signal in response to radiation;
   a set of optical modulators connected to respective ones of the sensing elements and configured to modulate a sensing light beam in response to the electrical signal; and
   a sensing optical system configured to direct the sensing light beam through each of the optical modulators.
2. The radiation detector of clause 1 wherein the optical modulators are arranged along a straight line and the sensing optical system guides the sensing light beam along a straight beam path through the optical modulators.
3. The radiation detector of clause 1 wherein the optical modulators are arranged in a two dimensional array and the sensing optical system guides the sensing light beam along a meandering beam path through the optical modulators.
4. The radiation detector of any of clauses 1 to 3 further comprising at least one further set of sensing elements, at least one further set of optical modulators, and at least one further sensing optical system.
5. The radiation detector of clause 4 further comprising a beam splitter configured to split an input light beam into a plurality of sensing light beams and to direct a sensing light beam into the sensing optical system and each further sensing optical system.
6. The radiation detector of clause 4 or 5 further comprising a beam combiner configured to combine the plurality of sensing light beams having passed through the sensing optical system or a further sensing optical system into a measurement beam.
7. The radiation detector of any of clauses 1 to 6 wherein the optical modulator is configured to modulate a property of the light beam selected from the group consisting of: phase, amplitude and polarization.
8. The radiation detector of any of clauses 1 to 7 wherein the optical modulators are configured to cumulatively modulate a property of the light beam so that the cumulative modulation of the property of the light beam is indicative of the electrical signals output by all of the sensing elements.
9. The radiation detector of clause 8 wherein the modulation of the light beam is indicative of the sum of the electrical signals, desirably a weighted sum of the electrical signals.
10. The radiation detector of any preceding clause further comprising a read out unit configured to measure the modulation of the light beam.
11. The radiation detector of clause 10 further comprising a reference optical system configured to provide a reference light beam to the read out unit.
12. The radiation detector of clause 10 or 11 wherein the read out unit is configured to operate at a rate of no less than 100 MHz, desirably no less than 200 MHz, more desirably no less than 400 MHz.
13. The radiation detector of any preceding clause wherein the sensing optical system, and any further sensing optical system, comprises a waveguide.
14. The radiation detector of any preceding clause wherein the set of sensing elements are formed on a first substrate and the set of optical modulators are formed on a second substrate; the second substrate being bonded to the first substrate.
15. The radiation detector of clause 14 further comprising a light source on the second substrate.
16. The radiation detector of any preceding clause wherein the set of sensing elements comprise CMOS devices.
17. The radiation detector of any preceding clause wherein the set of sensing elements comprise PIN diodes.
18. The radiation detector of any preceding clause wherein the set of optical modulators are formed on a silicon substrate.
19. The radiation detector of any preceding clause wherein each of the sensing elements has a radiation receiving area having a size no more than 500 µm by 500 µm, desirably no more than 200 µm by 200 µm, more desirably no more than 150 µm by 150 µm.
20. The radiation detector of any preceding clause comprising no less than 1,000 sensing elements, desirably no less than 5,000 sensing elements, more desirably no less than 10,000 sensing elements.
21. The radiation detector of any preceding clause wherein each sensing element is configured to generate an electrical signal in response to incident electrons, desirably a single incident electron, as the radiation.
22. The radiation detector of any preceding clause wherein each optical modulator is connected to a respective one of the sensing elements.
23. The radiation detector according to any preceding clause wherein each optical modulator is connected to a plurality of the sensing elements.
24. A charged particle detection system comprising a radiation detector of any preceding clause.
25. The charged particle detection system of clause 24 further comprising a secondary optical system configured to direct electrons emitted from a sample to the radiation detector.
26. A charged particle detection system comprising:
   a set of sensing elements configured to generate an electrical signal in response to radiation;
   a set of optical modulators connected to respective ones of the sensing elements and configured to modulate a sensing light beam in response to the electrical signal; and
   a sensing optical system configured to direct the sensing light beam through each of the optical modulators.
27. The charged particle detection system of clause 26 wherein the optical modulators are arranged along a straight line and the sensing optical system guides the sensing light beam along a straight beam path through the optical modulators.
28. The charged particle detection system of clause 26 wherein the optical modulators are arranged in a two dimensional array and the sensing optical system guides the sensing light beam along a meandering beam path through the optical modulators.
29. The charged particle detection system of any of clauses 26 to 28 further comprising a read out unit configured to measure the modulation of the light beam and to generate an output signal representing the total amount of radiation received by the set of sensing elements in a sampling period, desirably a weighted sum of the total amount of radiation received by the set of sensing elements in a sampling period.
30. The charged particle detection system of any of clauses 26 to 28 further comprising at least one further set of sensing elements, at least one further set of optical modulators, and at least one further sensing optical system.
31. The charged particle detection system of clause 30 further comprising a read out unit configured to measure the modulation of the light beams and to generate an output signal representing the total amount of radiation received by all the sets of sensing elements in a sampling period, desirably a weighted sum of the total amount of radiation received by all the sets of sensing elements in a sampling period.
32. The charged particle detection system of clause 30 further comprising a read out unit configured to measure the modulation of the light beams and to generate a plurality of output signals each representing the total amount of radiation received by one of the sets of sensing elements in a sampling period, desirably a weighted sum of the total amount of radiation received by the one of the sets of sensing elements in a sampling period.
33. The charged particle detection system of any of clauses 29, 31 or 32 further comprising a reference optical system configured to provide a reference light beam to the read out unit.
34. The charged particle detection system of any of clauses 29 or 31 to 33 wherein the read out unit is configured to operate at a rate of no less than 100 MHz, desirably no less than 200 MHz, more desirably no less than 400 MHz.
35. The charged particle detection system of any of clauses 26 to 34 wherein the optical modulator is configured to modulate a property of the light beam selected from the group consisting of: phase, amplitude and polarization.
36. The charged particle detection system of any of clauses 26 to 35 wherein the sensing optical system, and any further sensing optical system, comprises a waveguide.
37. The charged particle detection system of any of clauses 26 to 36 wherein the set of sensing elements are formed on a first substrate and the set of optical modulators are formed on a second substrate; the second substrate being bonded to the first substrate.
38. The charged particle detection system of any of clauses 26 to 37 wherein each of the sensing elements has a radiation receiving area having a size no more than 500 µm by 500 µm, desirably no more than 200 µm by 200 µm, more desirably no more than 150 µm by 150 µm.
39. The charged particle detection system of any of clauses 26 to 38 comprising no less than 1,000 sensing elements, desirably no less than 5,000 sensing elements, more desirably no less than 10,000 sensing elements.
40. The charged particle detection system of any of clauses 26 to 39 wherein each optical modulator is connected to a respective one of the sensing elements.
41. The charged particle detection system according to any of clauses 26 to 39 wherein each optical modulator is connected to a plurality of the sensing elements.
42. The charged particle detection system of any of clauses 26 to 41 further comprising a secondary optical system configured to direct electrons emitted from a sample to the set(s) of sensing elements.
43. A method of detecting radiation comprising:
   directing radiation to a plurality of sensing elements that are configured to generate electrical signals in response to the radiation;
   modulating a sensing light beam in response to the electrical signals; and
   measuring the modulation of the sensing light beam to detect the radiation.
44. The method of clause 43 wherein the modulating comprises guiding the sensing light beam along a straight beam path through a set of the optical modulators connected to a set of the sensing elements.
45. The method of clause 43 wherein the modulating comprises guiding the sensing light beam along a meandering beam path through optical modulators arranged in a two dimensional array.
46. The method of any of clauses 43 to 45 the modulating comprises guiding a plurality of sensing light beams along a beam paths through respective sets of the optical modulators.
47. The method of clause 46 further comprising splitting an input light beam into a plurality of sensing light beams.
48. The method of clause 46 or 47 further comprising combining the plurality of sensing light beams into a measurement beam after the modulation.
49. The method of any of clauses 43 to 48 wherein the modulating comprises modulating a property of the light beam selected from the group consisting of: phase, amplitude and polarization.
50. The method of any of clauses 43 to 49 wherein the modulation comprises cumulatively modulating a property of the light beam so that the modulation of the light beam is indicative of the electrical signals output by all of the sensing elements.
51. The method of clause 50 wherein the modulation of the light beam is indicative of the sum of the electrical signals, desirably a weighted sum of the total amount of radiation received by the sensing elements in a sampling period.
52. The method of any of clauses 43 to 50 further comprising measuring the modulation of the light beam.
53. The method of clause 52 wherein measuring comprises measuring the modulation relative to a reference light beam.
54. The method of clause 52 or 53 wherein measuring comprising measuring the modulation at a rate of no less than 100 MHz, desirably no less than 200 MHz, more desirably no less than 400 MHz.
55. The method of any of clauses 43 to 54 wherein each sensing element is configured to generate an electrical signal in response to incident electrons, desirably a single incident electron, as the radiation.
56. A charged particle detector comprising:
   an array of sensing elements configured to generate an electrical signal in response to charged particles and arranged in rows;
   an array of optical modulators each connected to a respective one of the sensing elements and configured to modulate a sensing light beam in response to the electrical signal;
   a plurality of waveguides configured to direct each of a plurality of sensing light beams through a row of the optical modulators;
   a beam combiner configured to combine the plurality of sensing light beams having passed through respective rows of the optical modulator into a combined beam; and
   a read out unit configured to measure the modulation of the combined beam to detect charged particles incident on the sensing elements.
57. A non-transitory computer readable medium including a set of instructions that is executable by one or more processors of a controller to cause the controller to perform a method for controlling deflectors of a charged-particle inspection system, the method comprising:
   causing radiation to be directed to a plurality of sensing elements that generate electrical signals in response to the radiation and that are part of a detection component that is configured to modulate a sensing light beam in response to the electrical signals and to measure the modulation of the sensing light beam to detect the radiation; and
   causing the detection component to output a signal indicative of the measured modulation.
58. The non-transitory computer readable medium of clause 57, wherein the set of instructions that is executable by the one or more processors of the controller to cause the controller to further perform:
   generating an image based on the signal indicative of the measured modulation, wherein the detection component includes optical modulators that are configured to cumulatively modulate a property of the light beam, wherein the cumulative modulation of the property of the light beam is indicative of the electrical signals output by all of the sensing elements, and wherein the signal indicative of the measured modulation is indicative of the cumulative modulation of the property of the light beam.

It will be appreciated that the present invention is not limited to the exact construction that has been described above and illustrated in the accompanying drawings, and that various modifications and changes can be made without departing from the scope thereof. For example, while a PIN diode has been discussed with reference to certain exemplary embodiments, other types of diodes, such as a NIP diode may be similarly applied. Furthermore, other types of devices that may generate a measurable signal in response to receiving incident energy may be applied in a detector.

It will be understood that elements shown in separate figures may be combined.

Furthermore, while scanning electron microscopy has been discussed with reference to some embodiments, other types of systems may be applicable as well. For example, a detector may be used in transmission electron microscopy (TEM), scanning transmission electron microscopy (STEM), or structured illumination microscopy (SIM) systems.

## Claims

1. A radiation detector comprising:
a set of sensing elements configured to generate an electrical signal in response to radiation;
a set of optical modulators connected to respective ones of the sensing elements and configured to modulate a sensing light beam in response to the electrical signal; and
a sensing optical system configured to direct the sensing light beam through each of the optical modulators.

2. The radiation detector of claim 1 wherein the optical modulators are arranged along a straight line and the sensing optical system guides the sensing light beam along a straight beam path through the optical modulators.

3. The radiation detector of claim 1 wherein the optical modulators are arranged in a two dimensional array and the sensing optical system guides the sensing light beam along a meandering beam path through the optical modulators.

4. The radiation detector of claim 1 further comprising at least one further set of sensing elements, at least one further set of optical modulators, and at least one further sensing optical system.

5. The radiation detector of claim 4 further comprising a beam splitter configured to split an input light beam into a plurality of sensing light beams and to direct a sensing light beam into the sensing optical system and each further sensing optical system.

6. The radiation detector of claim 4 further comprising a beam combiner configured to combine the plurality of sensing light beams having passed through the sensing optical system or a further sensing optical system into a measurement beam.

7. The radiation detector of any of claim 1 wherein the optical modulator is configured to modulate a property of the light beam selected from the group consisting of: phase, amplitude and polarization.

8. The radiation detector of any of claim 1 wherein the optical modulators are configured to cumulatively modulate a property of the light beam so that the cumulative modulation of the property of the light beam is indicative of the electrical signals output by all of the sensing elements.

9. The radiation detector of claim 8 wherein the modulation of the light beam is indicative of the sum of the electrical signals, desirably a weighted sum of the electrical signals.

10. The radiation detector of claim 1 further comprising a read out unit configured to measure the modulation of the light beam.

11. The radiation detector of claim 10 further comprising a reference optical system configured to provide a reference light beam to the read out unit.

12. The radiation detector of claim 1 wherein the sensing optical system, and any further sensing optical system, comprises a waveguide.

13. The radiation detector of claim 1 wherein the set of sensing elements are formed on a first substrate and the set of optical modulators are formed on a second substrate; the second substrate being bonded to the first substrate.

14. The radiation detector of claim 1 wherein each optical modulator is connected to a respective one of the sensing elements.

15. A non-transitory computer readable medium including a set of instructions that is executable by one or more processors of a controller to cause the controller to perform a method for controlling deflectors of a charged-particle inspection system, the method comprising:
causing radiation to be directed to a plurality of sensing elements that generate electrical signals in response to the radiation and that are part of a detection component that is configured to modulate a sensing light beam in response to the electrical signals and to measure the modulation of the sensing light beam to detect the radiation; and
causing the detection component to output a signal indicative of the measured modulation.
